# FASCICULE DE BREVET EUROPEEN

(11) **EP 2 765 576 B1**
(45) Date de publication et mention de la délivrance du brevet: **06.11.2019**
(21) Numéro de dépôt: 14154348.8
(22) Date de dépôt: 07.02.2014
(51) Int. Cl.: G11C 13/00, G11C 17/16

(54) **Procédé de préprogrammation d'une cellule mémoire à changement de phase**
Vorprogrammierungsverfahren einer Speicherzelle mit Phasenwechsel
Method for pre-programming a phase-changing memory cell

(30) Priorité: 08.02.2013 FR 1351094
(43) Date de publication de la demande: 13.08.2014
(73) Titulaire: COMMISSARIAT À L'ÉNERGIE ATOMIQUE ET AUX ÉNERGIES ALTERNATIVES, 75015 Paris (FR); Institut Polytechnique de Grenoble, 38000 Grenoble (FR)
(72) Inventeur: Hubert, Quentin, 38000 Grenoble (FR); Jahan, Carine, 38100 Grenoble (FR)
(74) Mandataire: Hautier, Nicolas

(56) Documents cités:
- EP-A1- 1 710 807
- EP-A1- 2 402 953
- WO-A1-2005/017906
- WO-A1-2007/141865
- US-A1- 2009 237 985

## Description

### DOMAINE TECHNIQUE DE L'INVENTION

La présente invention concerne, en général, les mémoires résistives non volatiles, et plus particulièrement, les mémoires résistives pouvant être utilisées dans le cadre d'un processus industriel de fabrication de systèmes embarqués où il est très avantageux de pouvoir les préprogrammer dans leur environnement de fabrication sans que les informations stockées puissent être ensuite perdues en raison des contraintes thermiques subies, notamment celles d'assemblage comprenant des étapes de soudage ou de brasage par refusion des composants.

### ÉTAT DE LA TECHNIQUE

Les systèmes embarqués informatisés font toujours très largement appel, en plus des éléments électroniques, optiques ou mécaniques propres à chaque système, à l'utilisation de microprocesseurs ou de microcontrôleurs et aux mémoires électroniques nécessaires pour assurer leur fonctionnement. Typiquement, tous les composants constituant un système embarqué sont assemblés sur un ou plusieurs circuits imprimés ou cartes électroniques souvent aussi désignés par leur vocable anglais de PCB, c'est-à-dire « printed circuit board ». L'assemblage est généralement automatisé dans une chaîne de fabrication. Les composants électroniques se présentent le plus souvent sous la forme de composants destinés à être montés en surface (sans broches traversantes). Ils sont alors simplement posés sur le circuit imprimé par une machine de placement. Préalablement, un dépôt d'une pâte de soudage ou de brasage sur les terminaisons des composants et/ou celles du circuit imprimés aura été effectué. On fait ensuite passer le circuit imprimé sur lequel les composants ont été placés dans un four de chauffage, typiquement un four dit tunnel où le gradient de température est réglé pour faire fondre la pâte déposée qui assure, après refroidissement, une fixation mécanique des composants et un excellent contact électrique. Cette opération standard de fabrication d'un circuit imprimé est qualifiée de soudage ou brasage par refusion ou encore, dans la littérature technique en anglais, de « solder reflow ».

Presque toujours, une partie au moins des mémoires constituant un système embarqué est de type non volatile. Par exemple, pour pouvoir y stocker de façon permanente le code opérationnel, généralement appelé microcode, du ou des microprocesseurs ou microcontrôleurs qui servent à réaliser la fonction pour laquelle le système embarqué a été conçu. Il est alors de pratique courante que le processus de fabrication demande que la partie non volatile des mémoires puisse être programmée avant leur montage sur le circuit imprimé. Un avantage très important de cette façon de faire est qu'on peut alors, par exemple, préprogrammer dans la partie non volatile un code spécifique destiné à tester le circuit imprimé dès après assemblage de façon à vérifier son intégrité. Un autre exemple d'avantage lié à la possibilité de pouvoir préprogrammer les mémoires non volatiles concerne les cartes à puce sécurisées souvent désignées par leur vocable anglais de « secure smart cards ». Les émetteurs de telles cartes, par exemple les banques, préfèrent de beaucoup que les données confidentielles qu'elles contiennent puissent y être introduites avant assemblage afin de ne pas avoir à contrôler la distribution de ces informations sensibles au-delà de la chaîne de fabrication.

Si le code opérationnel ou les données fonctionnelles que doivent contenir une mémoire non volatile n'ont pas été préprogrammés ils devront alors pouvoir être chargés in situ, c'est-à-dire dans la mémoire non volatile après qu'elle a été assemblée et interconnectée avec les autres composants sur le circuit imprimé. Des moyens ont été développés depuis longtemps par l'industrie de la microélectronique pour assurer cette fonction après assemblage. Une pratique courante est d'utiliser les circuits de tests qui sont contenus dans la quasi-totalité des circuits développés par cette industrie notamment les circuits dits JTAG, acronyme de l'anglais « Joint Test Action Group » qui désigne un groupe de travail qui a permis de définir une stratégie et des moyens de test des circuits imprimés dès le milieu des années 80 afin de pouvoir s'assurer, après fabrication, du bon fonctionnement de circuits de plus en plus complexes. Devenu un standard, les circuits JTAG permettent d'accéder individuellement aux composants assemblés sur un circuit imprimé à travers une interface série spécialisée qui peut aussi permettre une programmation in situ de la partie mémoire non volatile. La vitesse d'accès intrinsèquement faible et la bande passante disponible limitée de cette méthode font que le chargement du code est une opération qui peut prendre beaucoup de temps et ralentir la chaîne de fabrication.

D'autres moyens ont été conçus pour la programmation in situ de la partie non volatile des mémoires qui ont leurs propres inconvénients comme de nécessiter des points de connexion spécialisés qui n'auront aucune utilité fonctionnelle et/où une interface dédiée à cette fonction pour permettre d'une part, l'écriture du code dans la partie mémoire non volatile, et d'autre part, le contrôle des autres composants afin qu'ils puissent être inhibés pour ne pas interférer avec le chargement du code. Ceci ne manque pas de compliquer grandement la conception du système embarqué et nécessite aussi généralement le développement d'un outil de programmation spécialisé pour le chargement du code après assemblage dans la ligne de fabrication.

Chaque fois que c'est possible on préfère donc charger tout le code nécessaire, c'est-à-dire non seulement le code de test mais aussi le code fonctionnel, avant assemblage. Ceci évite d'avoir recours à une programmation in situ avec tous les inconvénients brièvement mentionnés ci-dessus.

Les mémoires non volatiles utilisées actuellement sont essentiellement des mémoires dites Flash dans lesquelles chaque point mémoire est un transistor métal-oxyde-semiconducteur (MOS) possédant une grille flottante dans lequel on piège des porteurs. La programmation de ces mémoires se fait en appliquant sur les électrodes des tensions plus élevées que celles utilisées pour leur lecture. Ces tensions permettent d'amener dans la grille flottante des charges, ou à les évacuer, afin de modifier de façon permanente, en lecture, le seuil de conduction du transistor pour pouvoir y stocker au moins deux niveaux électriques différents c'est-à-dire un bit d'information. Le piégeage et l'évacuation des porteurs se fait à travers la couche d'oxyde très mince formant la grille du transistor MOS en mettant en oeuvre des effets quantiques du type effet tunnel ou électron chaud. Ce type de stockage non volatile n'est pas particulièrement affecté par la température. Les mémoires Flash supportent très bien la programmation avant assemblage. Leur contenu n'est pas altéré par l'opération de soudage par refusion décrite précédemment dans laquelle, typiquement, la température maximum atteinte est de l'ordre de 245°C pour les pâtes de soudage contenant du plomb. L'emploi de pâtes sans plomb, maintenant requis pour leur caractère non polluant, augmente la température jusqu'à 260° C voire plus, ce qui reste sans effet négatif sur la rétention des données préprogrammées dans ce type de mémoire. L'inconvénient principal des mémoires Flash est que leur programmation nécessite, comme on l'a vu ci-dessus, de devoir appliquer des tensions importantes pour transférer des charges dans ou depuis la grille flottante. Leur écriture est une opération relativement lente et compliquée qui peut avoir à se faire, en fonction de leur structure interne de type dit ET ou OU, sur des blocks de cellules qui doivent être effacés avant d'être réécrits avec les nouvelles données.

C'est pourquoi les concepteurs de systèmes embarqués se tournent maintenant vers l'emploi d'autres types de mémoires non volatiles qui ne présentent pas ces inconvénients. Il s'agit notamment des mémoires dites « résistives » globalement désignées par le terme RRAM, acronyme de l'anglais « resistive random accès memory » c'est-à-dire « mémoire résistive à accès aléatoire » où la mémorisation se fait en modifiant électriquement, de façon réversible, le matériau qui compose chaque cellule de façon à ce qu'il puisse prendre au moins deux valeurs distinctes de résistance pour y stocker un bit d'information.

Parmi les mémoires résistives on trouve notamment celles utilisant un matériau à changement de phase dont on fait varier réversiblement la structure atomique sous l'effet de la chaleur. Désignées sous l'acronyme de PCM, de l'anglais « phase change memory » c'est-à-dire « mémoire à changement de phase » ces mémoires sont préférées pour le développement de nouveaux produits aux mémoires Flash car elles sont intrinsèquement plus denses et leur écriture beaucoup plus simple et rapide que les mémoires Flash. Typiquement, le matériau à changement de phase utilisé est un chalcogénure et notamment un alliage comprenant un ou plusieurs des éléments suivant : germanium (Ge), antimoine (Sb), tellure (Te), indium (In), gallium (Ga). De plus, il est possible de doper cet alliage en utilisant un ou plusieurs des éléments précédents ainsi que des éléments tels que le carbone, l'azote, l'oxygène, le silicium, l'hafnium ainsi que les composés de ces éléments. Le matériau à changement de phase le plus commun étant l'alliage de germanium, antimoine et tellure sous la forme Ge₂Sb₂Te₅, connu sous l'acronyme de GST.

Une mémoire à changement de phase est par exemple décrite dans les documents de l'art antérieur EP2402953 et WO2007/141865.

Conçues pour opérer à des températures jusqu'à 85°C pendant 10 ans les mémoires PCM sont intrinsèquement, du fait même de leur principe de fonctionnement très brièvement exposé ci-dessus, directement sensibles à la température de l'environnement dans lequel elles doivent fonctionner. Leur temps de rétention diminuant très rapidement en fonction de la température à laquelle elles sont soumises, les mémoires résistives de type PCM ne peuvent donc être utilement préprogrammées avant assemblage puisque les informations stockées sont alors perdues lors de la phase de soudage par refusion où des températures jusqu'à 260°C peuvent être appliquées.

Ainsi, la présente invention a pour objectif de proposer une solution pour permettre aux dispositifs intégrant une matrice de cellules mémoire à changement de phase de ne pas perdre, lors de l'assemblage, la pré-programmation de la matrice.

Les autres objets, caractéristiques et avantages de la présente invention apparaîtront à l'examen de la description suivante et des dessins d'accompagnement. Il est entendu que d'autres avantages peuvent être incorporés.

### RÉSUMÉ DE L'INVENTION

Selon un mode de réalisation, l'invention porte sur un procédé de pré-programmation d'une matrice de cellules mémoire résistives non volatiles à changement de phase selon la revendication 1.

Ainsi, on effectue au moins, après assemblage d'un composant contenant ladite matrice avec un support, une étape de lecture de la résistance de toutes les cellules de la matrice de manière à identifier les cellules qui se trouvent après assemblage dans ledit troisième état résistif (HRS assemblage) et celles qui se trouvent dans ledit quatrième état résistif (LRS assemblage). Cette étape consiste ainsi à lire l'état résistif de chaque cellule (HRS assemblage ou LRS assemblage). On peut ainsi en déduire les cellules qui étaient, avant assemblage, dans ledit état résistif originel (HRS originel) et celles qui étaient, avant assemblage, dans ledit deuxième état résistif (LRS claquage).

Le passage de l'état résistif originel (HRS originel) au troisième état résistif (HRS assemblage) est uniquement provoqué par l'étape d'assemblage. De même, Le passage du deuxième état résistif (LRS claquage) au quatrième état résistif (LRS assemblage) est uniquement provoqué par l'étape d'assemblage.

De manière préférée et optionnelle on effectue au moins les étapes suivantes après assemblage d'un composant contenant ladite matrice avec un support:
stockage des états résistifs (HRS assemblage, LRS assemblage) lus dans une mémoire auxiliaire de manière à sauvegarder la pré-programmation de la matrice,
application d'une tension de claquage à une pluralité au moins de cellules mémoire de manière à ce que toutes les couches de matériau diélectrique de tout ou partie des cellules mémoire de la matrice soient claquées, pour amener toutes les cellules de la matrice dans ledit quatrième état résistif (LRS claquage),
réécrire dans la matrice la pré-programmation sauvegardée dans la mémoire auxiliaire en modifiant le matériau à changement de phase d'une sélection de cellules mémoire.

Ainsi, avant assemblage d'un composant contenant ladite matrice sur un support, donc avant application d'un stress thermique important par exemple par soudage ou par brasage, on modifie la résistance de la cellule mémoire en altérant la couche diélectrique.

Il s'est avéré que l'état résistif originel (HRS originel) est stable même lorsqu'il est soumis à une haute température. Ainsi, la résistance de la cellule dans l'état HRS originel est égale ou sensiblement égale à la résistance de la cellule dans l'état HRS assemblage, i.e., la résistance des cellules non claquées n'est pas modifiée ou n'est que très peu modifiée par l'apport de chaleur provoqué par l'étape d'assemblage. De plus, la résistivité de la cellule amenée dans le deuxième état résistif (LRS claquage) varie suffisamment peu lorsque la cellule est soumise à une haute température pour que cet état reste très facilement différentiable de l'état résistif originel. Ainsi, même lorsque la matrice de cellules est soumise à un stress thermique important lorsqu'elle est assemblée sur un support, typiquement lorsqu'elle est soudée ou brasée sur une carte, elle conserve la pré-programmation.

Cette pré-programmation est de préférence ensuite sauvegardée dans une mémoire auxiliaire. Les couches de diélectrique de tout ou partie des cellules de la matrice sont ensuite claquées. Dans le cas où toutes les cellules mémoires n'auraient pas besoin d'être utilisées par la suite, il peut-être avantageux de laisser une partie des cellules de la matrice dans l'état HRS assemblage (notamment pour des gains de consommation électrique et de temps). Les cellules mémoire dont la couche de diélectrique a été claquée peuvent alors retrouver un fonctionnement habituel des cellules mémoire à changement de phase conventionnelle. Par exemple, la phase du matériau à changement de phase d'une même cellule peut être réversiblement modifiée pour écrire et effacer cette cellule mémoire.

La matrice est ensuite reprogrammée en modifiant la phase du matériau à changement de phase d'une sélection de cellule sur la base de la programmation sauvegardée dans la mémoire auxiliaire. Dans le cas où certaines données ne devraient être ni effacées, ni écrites, il peut-être avantageux de stocker ces données dans des cellules de la matrice dans l'état HRS assemblage et LRS assemblage car ces deux états sont extrêmement résistants à la température,

Après assemblage, la cellule mémoire peut alors présenter au moins deux états résistifs avant assemblage : un état résistif dans lequel la couche de matériau diélectrique n'est pas claquée avant assemblage et un autre état résistif dans lequel la couche de matériau diélectrique est claquée avant assemblage.

L'invention offre ainsi une solution simple et fiable pour conserver la programmation d'une matrice de cellules mémoire à changement de phase après une étape de montage au cours duquel un stress thermique important est appliqué à la matrice.

Par ailleurs, cette solution présente une grande simplicité d'intégration. Elle est compatible avec une solution de type wafer-level, c'est-à-dire une solution dans laquelle la pré-programmation est effectuée au niveau d'une tranche et avant découpe des puces dans la tranche.

L'invention permet également une grande liberté d'utilisation en offrant la possibilité d'utiliser des couches de matériau à changement de phase fabriquées dans des matériaux variés et en ajoutant simplement à la cellule mémoire la couche de matériau diélectrique.

On décrit également un procédé de pré-programmation d'une matrice de cellules mémoire résistives non volatiles, lesdites cellules mémoire comprenant un matériau à changement de phase disposé entre deux électrodes conductrices et apte à être modifié électriquement et réversiblement de manière à faire varier la résistance de la cellule mémoire. On prévoit pour chaque cellule mémoire une couche de matériau diélectrique disposée entre les deux électrodes conductrices, la cellule mémoire présentant un état résistif originel (HRS originel) en fin de procédé de fabrication de la cellule et avant tout étape de programmation des cellules. On effectue une étape de pré-programmation comprenant, avant assemblage de ladite matrice sur un support : l'application d'une tension de claquage à une sélection de cellules mémoire de manière à, pour chacune des cellules de cette sélection, faire claquer la couche de matériau diélectrique pour amener la cellule depuis l'état résistif originel (HRS originel) à un état deuxième résistif (LRS claquage) dans lequel la résistance de la cellule est au moins deux fois inférieure et de préférence cinq fois inférieure et encore plus préférentiellement dix fois inférieure à la résistance de la cellule dans l'état résistif originel (HRS originel).

Selon un aspect non couvert par les revendications, on prévoit une cellule mémoire à changement de phase comprenant un matériau à changement de phase et au moins une électrode, caractérisée en ce qu'elle comprend une couche diélectrique disposée entre la couche du matériau à changement de phase et l'électrode de manière à ce que la cellule mémoire présente initialement un état résistif originel (HRS originel), la cellule mémoire étant configurée pour permettre de faire sélectivement claquer la couche diélectrique de manière à ce que la résistance de la cellule mémoire soit, après claquage, dans un deuxième état résistif (LRS claquage) dont la résistance est au moins deux fois inférieure à la résistance de la cellule mémoire dans l'état résistif originel (HRS originel).

De préférence, la résistance de la cellule dans l'état résistif originel (HRS originel) est au moins cinq fois supérieure et plus préférentiellement au moins 10 fois supérieure à la résistance de la cellule dans ledit deuxième état résistif (LRS claquage).

Selon un mode de réalisation, la couche diélectrique est au contact d'au moins l'un parmi la couche de matériau à changement de phase et un élément chauffant. La surface de contact entre la couche diélectrique et l'au moins un parmi la couche de matériau à changement de phase et un élément chauffant est inférieure à la surface de la face de la couche de diélectrique au regard de l'au moins un parmi la couche de matériau à changement de phase et un élément chauffant.

Selon un aspect non couvert par les revendications, on prévoit une cellule mémoire à changement de phase comprenant un matériau à changement de phase et au moins une électrode, caractérisée en ce qu'elle comprend une couche diélectrique disposée entre la couche de matériau à changement de phase et l'électrode de manière à ce que la cellule mémoire présente initialement un état résistif originel (HRS originel), la cellule mémoire étant configurée pour permettre de faire sélectivement claquer la couche diélectrique de manière à ce que la résistance de la cellule mémoire soit, après claquage, dans un deuxième état résistif (LRS claquage) tel que les cellules se trouvant avant assemblage dans ledit état résistif originel (HRS originel) se trouvent après l'étape d'assemblage dans un troisième état résistif (HRS assemblage), que les cellules se trouvant avant assemblage dans ledit deuxième état résistif (LRS claquage) se trouvent après l'étape d'assemblage dans un quatrième état résistif (LRS assemblage), et que la résistance des cellules se trouvant dans le troisième état résistif (HRS assemblage) est au moins deux fois supérieure à la résistance des cellules se trouvant dans le quatrième état résistif (LRS assemblage).

Selon un mode de réalisation avantageux, la résistance de la cellule mémoire est configurée pour varier en fonction de la phase du matériau à changement de phase. Ainsi, la cellule mémoire est configurée pour retrouver un fonctionnement standard de la cellule mémoire à changement de phase après claquage de la couche diélectrique.

Selon un mode de réalisation avantageux et optionnel, la résistance dans l'état résistif originel est supérieure ou égale à 1^{e}7 ohms. Cette valeur dépend par exemple du matériau utilisé, de son épaisseur, de l'aire de contact, de sa méthode de fabrication, de sa phase (amorphe, cristallin).

Selon un mode de réalisation avantageux et optionnel, la résistance après claquage de la couche diélectrique est inférieure ou égale à 1^{e}6 ohms.

Selon un mode de réalisation la cellule mémoire est configurée de manière à ce que le courant passant entre les deux électrodes conductrices traverse la couche diélectrique, la couche diélectrique étant au contact d'au moins l'un parmi la couche de matériau à changement de phase et un élément chauffant. La surface de contact entre la couche diélectrique et l'au moins un parmi la couche de matériau à changement de phase et un élément chauffant est inférieure à la surface de la face de la couche de diélectrique au regard de l'au moins un parmi la couche de matériau à changement de phase et un élément chauffant.

Selon un mode de réalisation la couche de matériau à changement de phase présente une portion tubulaire. La surface de contact entre la couche de matériau à changement de phase et le matériau diélectrique est un anneau ce qui permet de réduire cette surface par rapport à une solution dans laquelle cette surface est un disque.

Selon un mode de réalisation la couche de matériau à changement de phase est formée d'un cylindre dont le diamètre est inférieur à la surface de la face du matériau diélectrique au contact de ce cylindre.

Selon un mode de réalisation la couche de matériau diélectrique est disposée au contact de la couche de matériau à changement de phase et d'un élément conducteur. Selon un mode de réalisation l'élément conducteur présente une portion tubulaire et dans lequel la surface de contact entre l'élément conducteur et le matériau diélectrique est un anneau.

Selon un mode de réalisation la couche de matériau diélectrique est disposée au contact d'un premier élément conducteur et d'un deuxième élément conducteur et est insérée entre le premier élément conducteur et le deuxième élément conducteur.

La couche diélectrique est formée par une seule couche de matériau. Alternativement elle est formée par un empilement de plusieurs couches diélectriques. L'alternative comprenant plusieurs couches présente de nombreux avantages. Par exemple, l'une ou certaines des couches de diélectriques peuvent avoir un rôle mécanique, par exemple pour améliorer l'adhérence ou la conformité ou la rugosité. Cette couche peut par exemple être de l'alumine (Al2O3). Une ou des autre(s) couche(s) peuvent former le diélectrique que l'on cherche effectivement à claquer. De plus, chaque couche pourrait avoir un rôle électrique. Par exemple, une couche pourrait servir de limiteur de courant pendant le claquage d'une autre couche ce qui pourrait permettre de mieux contrôler le claquage.

Dans la présente invention, on entend par dispositif microélectronique tout type de dispositif réalisé avec des moyens de la microélectronique. Ces dispositifs englobent notamment en plus des dispositifs à finalité purement électronique, des dispositifs micromécaniques ou électromécaniques (MEMS, NEMS...) ainsi que des dispositifs optiques ou optoélectroniques (MOEMS...)

De manière préférée mais non limitative, le dispositif microélectronique est configuré pour sauvegarder dans la mémoire auxiliaire les informations stockées dans la matrice et pour, après claquage des couches diélectriques de tout ou partie des cellules de la matrice, réécrire les cellules mémoire en fonction des informations sauvegardées dans la mémoire auxiliaire.

### BRÈVE DESCRIPTION DES FIGURES

Les buts, objets, ainsi que les caractéristiques et avantages de l'invention ressortiront mieux de la description détaillée d'un mode de réalisation de cette dernière qui est illustré par les dessins d'accompagnement suivants dans lesquels :
Les FIGURES 1a à 1d illustrent des structures de cellule mémoire de type PCM typiques de l'art antérieur.
Les FIGURES 2a à 2f illustrent des structures de cellule mémoire de type PCM selon l'invention comprenant une fine couche diélectrique additionnelle.
Les FIGURES 3a et 3b illustrent des méthodes de claquage de la couche diélectrique.
La FIGURE 4 montre les tensions qu'il faut appliquer pour obtenir le claquage électrique de la couche diélectrique dans une cellule mémoire.
La FIGURE 5 compare les états faiblement résistifs obtenus après application de la procédure de claquage à ceux hautement résistifs obtenus initialement en fin de cycle de fabrication et leur évolution après application d'un stress thermique.
La FIGURE 6 illustre les étapes du procédé de préprogrammation d'une matrice de cellules mémoires selon l'invention.

Les dessins joints sont donnés à titre d'exemples et ne sont pas limitatifs de l'invention.

### DESCRIPTION DÉTAILLÉE DE L'INVENTION

Il est précisé que dans le cadre de la présente invention, le terme « sur », « surmonte » ou « sous jacent » ou leurs équivalents ne signifient pas obligatoirement « au contact de ». Ainsi par exemple, le dépôt d'une première couche sur une deuxième couche, ne signifie pas obligatoirement que les deux couches sont directement au contact l'une de l'autre mais cela signifie que la première couche recouvre au moins partiellement la deuxième couche en étant soit directement à son contact soit en étant séparée d'elle par une autre couche ou un autre élément.

Dans le cadre de la présente invention, on appelle pré-programmation, une programmation de certaines cellules mémoire au moins qui est effectuée avant assemblage de la matrice sur un support, typiquement au cours d'une opération mettant en jeu une température supérieure ou égale à 200°C.

Avant de présenter une description détaillée d'un exemple de réalisation de l'invention, des modes de réalisations avantageux sont maintenant mentionnés. Ces modes de réalisation peuvent être pris seuls ou en combinaison.
- Selon un mode de réalisation, le courant passant entre les deux électrodes conductrices traverse le matériau diélectrique. De préférence, tout le courant passant d'une électrode conductrice à l'autre traverse nécessairement le matériau diélectrique.
- L'étape de pré-programmation comprend l'application d'une tension de claquage à une sélection de cellules mémoire de manière à, pour chacune des cellules de cette sélection, faire claquer la couche de matériau diélectrique pour amener la cellule depuis l'état résistif originel (HRS originel) à un deuxième état résistif (LRS claquage) tel que la résistance (LRS assemblage), mesurée après l'étape d'assemblage, de chaque cellule se trouvant avant assemblage dans ledit deuxième état résistif (LRS claquage) est au moins cinq fois inférieure et encore plus préférentiellement dix fois inférieure à la résistance (HRS assemblage), mesurée après l'étape d'assemblage, de chaque cellule se trouvant avant assemblage dans ledit état résistif originel (HRS originel).
- Avantageusement, à l'issue de l'étape de pré-programmation, on laisse les cellules n'appartenant pas à ladite sélection de cellules dans l'état résistif originel.
- Typiquement, l'étape d'assemblage comprend une étape de brasage ou de soudage du composant sur le support.
- Alternativement, l'étape d'assemblage comprend un procédé de type WLCSP (acronyme de Wafer Level Chip Scale Packages dont une traduction en français peut être procédé de réalisation d'un boitier à la taille d'une puce au niveau du substrat).
- Selon un mode de réalisation privilégié, l'étape d'assemblage comprend une étape au cours de laquelle les cellules mémoire sont soumises à une température d'au moins 240 °C pendant au moins 10 secondes. De préférence, l'étape d'assemblage comprend l'application d'une température supérieure ou égale à 260 degrés Celsius pendant au moins 10 secondes.
- De préférence, l'étape d'assemblage, typiquement par WLCSP, comprend une étape au cours de laquelle les cellules mémoire sont soumises à une température supérieure à 300°C pendant plusieurs minutes. De préférence, l'étape d'assemblage comprend l'application d'une température supérieure ou égale à 300 degrés Celsius pendant au moins 30 minutes. De préférence, l'étape d'assemblage comprend l'application d'une température comprise entre 320°C et 375°C pour une durée comprise entre 40 et 80 minutes.
- De préférence, l'étape d'assemblage du composant contenant ladite matrice avec le support comprend l'assemblage du composant sur une carte imprimée ou sur une carte électronique ou avec un autre composant électronique ou sur un boîtier. Typiquement l'étape d'assemblage consiste à souder ou braser un composant comportant la matrice de cellules mémoire sur une carte mère.
- Selon un mode de réalisation avantageux, au cours de l'étape d'application d'une tension de claquage à une pluralité au moins de cellules mémoire de manière à ce que toutes les couches de matériau diélectrique de toutes les cellules mémoire de la matrice soient claquées, la tension de claquage est appliquée uniquement aux cellules se trouvant dans l'état HRS assemblage. Avantageusement, cela permet de n'appliquer la tension de claquage qu'aux seules cellules qui le requièrent, les autres cellules étant déjà dans l'état LRS assemblage à l'issue de l'étape de pré-programmation. La rapidité du procédé est ainsi augmentée et la puissance consommée est réduite. En outre, l'étape de lecture préalable permet d'identifier les cellules dont la couche de matériau diélectrique est déjà claquée et celles pour lesquelles cela reste à faire.

De préférence, l'application d'une tension de claquage à une sélection de cellules mémoire comprend, pour chacune des cellules de cette sélection, l'application d'une rampe de tension de préférence comprise entre une tension nulle ou minimale et 10 volts et de préférence entre une tension nulle ou minimale et 5 volts dans une durée de préférence inférieure à 500 milli secondes et de préférence inférieure à 100 milli secondes.

Alternativement, l'application d'une tension de claquage à une sélection de cellules mémoire comprend, pour chacune des cellules de cette sélection, l'application d'une succession de pulses de tension. De préférence l'amplitude des pulses est croissante. De préférence, la durée des pulses est inférieure à 1 milliseconde et de préférence inférieure à 500 microsecondes.

Alternativement, l'application d'une tension de claquage à une sélection de cellules mémoire comprend, pour chacune des cellules de cette sélection, l'application d'une tension constante.

L'invention s'applique à toutes les cellules mémoires pour lesquelles la distribution des résistances dans l'état HRS assemblage ne chevauche pas la distribution des résistances dans l'état LRS assemblage. Ainsi un écart de résistance doit être présent entre ces distributions. De préférence cet écart de résistance est d'au moins un facteur 10.
- Avantageusement, les résistances des cellules mémoire de la matrice dans l'état résistif originel (HRS originel) sont comprises dans une première plage de valeurs, les résistances des cellules mémoire de la matrice dans le deuxième état résistif (LRS claquage) sont comprises dans une deuxième plage de valeurs et les première et deuxième plages sont disjointes avant l'étape d'assemblage.
- Avantageusement, les résistances des cellules mémoire de la matrice dans ledit troisième état résistif (HRS assemblage) sont comprises dans une première plage de valeurs, les résistances des cellules mémoire de la matrice dans le ledit quatrième état résistif (LRS assemblage) sont comprises dans une deuxième plage de valeurs et les première et deuxième plages sont disjointes après l'étape d'assemblage.
- De préférence, les première et deuxième plages présentent un écart d'au moins un ordre de grandeur (x10) et de préférence d'au moins deux ordres de grandeur (x100). Ainsi, la résistance de la cellule mémoire dans l'état résistif originel est au moins 10 fois supérieure et de préférence 100 fois supérieure à la résistance de la cellule mémoire dans le deuxième état résistif. Cet intervalle se vérifie après l'étape d'assemblage c'est à dire après l'application d'une température élevée.
- Selon un mode de réalisation privilégié, la lecture de l'état résistif de toutes les cellules mémoire de la matrice comprend : l'application sur chaque cellule mémoire d'une tension de lecture comprise entre 50 mV et 0,7 V ; la mesure de l'intensité du courant traversant la cellule mémoire pour en déduire si la résistance de cette cellule mémoire est dans l'état résistif originel (HRS originel) ou dans le deuxième état résistif (LRS claquage).
- Selon un mode de réalisation privilégié, la couche de diélectrique est au contact de la couche de matériau à changement de phase et optionnellement d'une électrode.
- Selon un mode de réalisation, la couche de matériau à changement de phase présente une portion tubulaire et la surface de contact entre la couche de matériau à changement de phase et le matériau diélectrique est un anneau. De préférence le fond du tube, situé à l'extrémité du tube qui est opposée à l'extrémité du tube au contact de la couche de matériau diélectrique est plein. Alternativement, la couche de matériau à changement de phase est formée d'un cylindre plein tel un pilier dont le diamètre est inférieur à la surface de la face du matériau diélectrique au contact de ce cylindre.
- Selon un mode de réalisation privilégié, la couche de diélectrique est disposée au contact de la couche de matériau à changement de phase et d'un élément conducteur. Selon un mode de réalisation l'élément conducteur présente une portion tubulaire et dans lequel la surface de contact entre l'élément conducteur et le matériau diélectrique est un anneau.
- Selon un mode de réalisation privilégié, la couche de diélectrique est disposée au contact d'un premier élément conducteur et d'un deuxième élément conducteur et est insérée entre le premier élément conducteur et le deuxième élément conducteur.
- Selon un mode de réalisation privilégié, la cellule comprend au moins deux couches de matériau à changement de phase et la couche de diélectrique est insérée entre les deux couches de matériau à changement de phase.
- Selon un mode de réalisation privilégié, la cellule comprend une pluralité de couches formant la couche de diélectrique.
- Selon un mode de réalisation, l'élément conducteur est configuré pour appliquer un courant et une tension à la couche de matériau diélectrique. Sous l'effet de cet apport de courant et de tension, la couche de matériau diélectrique claque ce qui modifie l'état résistif de la cellule. De préférence, cet élément conducteur confine la zone sur laquelle le courant et la tension sont appliqués. De préférence, il présente un diamètre externe inférieur à celui de la couche diélectrique. Il forme ainsi un élément de confinement de la zone activée par application d'un courant et d'une tension.
- Selon un mode de réalisation, l'élément conducteur est configuré pour chauffer lorsqu'il est parcouru par un courant. La chaleur produite peut alors être transmise au matériau à changement de phase pour changer la phase de ce dernier.
- Selon un mode de réalisation, l'élément conducteur est configuré pour conduire un courant jusqu'au matériau à changement de phase. Sous l'effet de cet apport de courant, le matériau à changement de phase s'échauffe et change de phase ce qui modifie l'état résistif de la cellule.
- De préférence, l'application d'un courant traversant les électrodes et le matériau à changement de phase permet de modifier la phase du matériau à changement de phase est donc de modifier la résistance de la cellule mémoire lorsqu'elle fonctionne comme une mémoire à changement de phase conventionnelle.
- Selon un mode de réalisation privilégié, la couche de matériau diélectrique présente une résistance supérieure ou égale à 1^{e}7 ohms et de préférence supérieure ou égale 1^{e}10 ohms avant application de la tension de claquage.
- De préférence, la couche de matériau diélectrique présente une résistance inférieure ou égale à 1^{e}6 ohms et de préférence inférieure ou égale 1^{e}4 ohms après application de la tension de claquage.
- Avantageusement, on choisit la couche de matériau diélectrique de manière à ce quelle soit rendue conductrice par application d'une rampe de tension ou d'une succession de pulses de tension ou d'une tension continue à température ambiante. De préférence, la tension maximum appliquée pendant la rampe de tension ou pendant la succession de pulses de tension ou pendant la tension continue est inférieure à la tension maximale que peut délivrer la circuiterie de l'application visée, soit typiquement 5V pour les applications mobiles.
- Selon un mode de réalisation privilégié, la couche de matériau diélectrique a une épaisseur inférieure à 25 nm et de préférence comprise entre 2 nm et 10 nm. De manière plus générale, le matériau utilisé, son épaisseur, l'aire de l'élément conducteur en contact avec le matériau diélectrique, la structure de la cellule, sont choisis de manière à ce que dans l'état originel, le matériau diélectrique ait peu de fuite (donc une résistance HRS originelle élevée) mais qu'il puisse être claqué avec une tension relativement faible (<5V) pour que ce claquage ne détériore/détruise pas la cellule mémoire, que ce claquage soit stable dans le temps et que l'état LRS obtenu ait une résistance suffisamment différente de celle de l'état HRS.
- Avantageusement, la couche de matériau diélectrique est formée par un matériau offrant une résistance dans l'état originel élevée et pouvant être claqué. Des exemples non limitatifs de tels matériaux sont les oxydes, les oxynitrures, à base de silicium, d'hafnium, de zirconium, de titane, d'azote, d'oxygène ainsi que les composés élaborés à partir de ces éléments. Des exemples de tels matériaux sont l'oxyde d'hafnium (HfO2), l'oxyde de titane (TiO2), l'oxyde de zirconium (ZrO2), l'oxyde de silicium (SiO2).
- Avantageusement, le matériau à changement de phase utilisé est un chalcogénure et notamment un alliage comprenant un ou plusieurs des éléments suivant : germanium (Ge), antimoine (Sb), tellure (Te), indium (In), gallium (Ga). De plus, il est possible de doper cet alliage en utilisant un ou plusieurs des éléments précédents ainsi que des éléments tels que le carbone, l'azote, l'oxygène, le silicium.

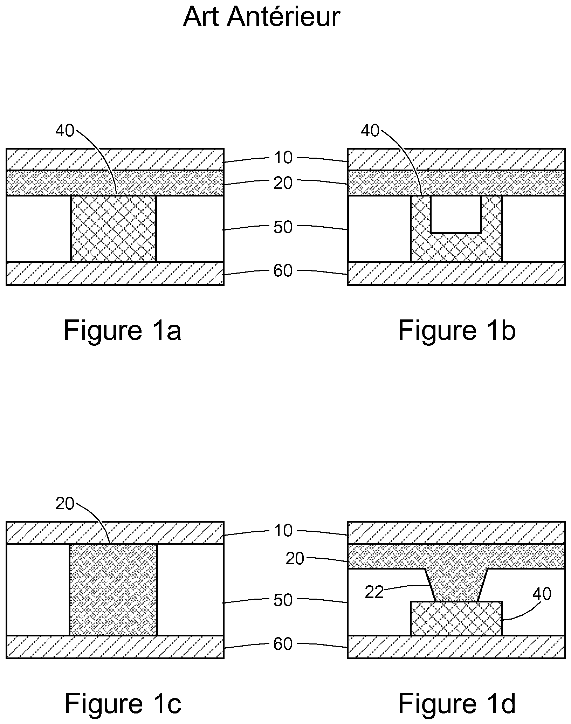

Les **figures 1a à 1d** illustrent des structures de cellules mémoire de type PCM typiques de l'art antérieur. On notera ici qu'il existe de très nombreuses structures de telles cellules mémoire. Les figures 1a à 1d ne sont que des exemples de cellules mémoire résistives auxquelles l'invention peut s'appliquer. Ces exemples ne sont en rien limitatifs, toutes les structures de cellules mémoire PCM connues sont susceptibles de pouvoir bénéficier de l'invention.

D'une façon générale, quelle que soit la structure, le matériau à changement de phase est toujours placé entre deux éléments conducteurs pouvant être de formes variées et faits de matériaux divers incluant notamment les matériaux couramment utilisés en microélectronique pour la réalisation des interconnexions c'est-à-dire l'aluminium (Al), le cuivre (Cu), le silicium (Si), le tantale (Ta), le titane (Ti), l'azote (N), le carbone (C) ainsi que les alliages obtenus à partir de ces matériaux. Ces éléments conducteurs destinés à l'interconnexion des cellules mémoire entre elles et avec les autres composants d'un dispositif électronique comprennent une première électrode ou électrode supérieure 10 et une seconde électrode ou électrode inférieure 60.

Suivant les structures, le matériau à changement de phase se présente sous la forme d'une couche 20 qui peut être d'épaisseur constante comme dans les structures des figures 1a, 1b et 1c ou remplir des cavités ou tranchées 22 qui ont été aménagées dans l'épaisseur de la cellule comme dans l'exemple de la figure 1d. La couche de matériau à changement de phase peut couvrir la totalité de la surface de la cellule comme dans les figures 1a et 1b ou une partie seulement comme montré dans l'exemple de la figure 1c.

Optionnellement, il existe un troisième élément conducteur 40 qui sert alors généralement de moyen de chauffage de la couche à changement de phase 20 afin de la faire transiter localement entre ces différentes phases : cristalline, non cristalline et/ou amorphe. Cet élément conducteur est alors fait d'un matériau conducteur pouvant résister à la chaleur. Typiquement, il est fait de tungstène (W).

Le moyen de chauffage peut prendre différentes formes. Il peut se présenter sous la forme d'un pilier plein, de section typiquement circulaire, comme dans la figure 1a ou sous la forme d'un anneau partiellement creux comme dans la figure 1b.

La cellule de la figure 1c est un exemple de structure dite confinée qui ne comprend pas de troisième élément conducteur et dans laquelle la couche de matériau à changement de phase est auto chauffante.

Enfin, quelle que soit la structure, elle est le plus souvent complétée par un matériau diélectrique 50 servant notamment à l'isolation du troisième élément conducteur et/ou du matériau à changement de phase s'il ne couvre pas toute la surface de la cellule comme dans l'exemple de la figure 1c. Suivant les modes de réalisation ce matériau est typiquement de l'oxyde de silicium (SiO2) ou du nitrure de silicium (SiN).

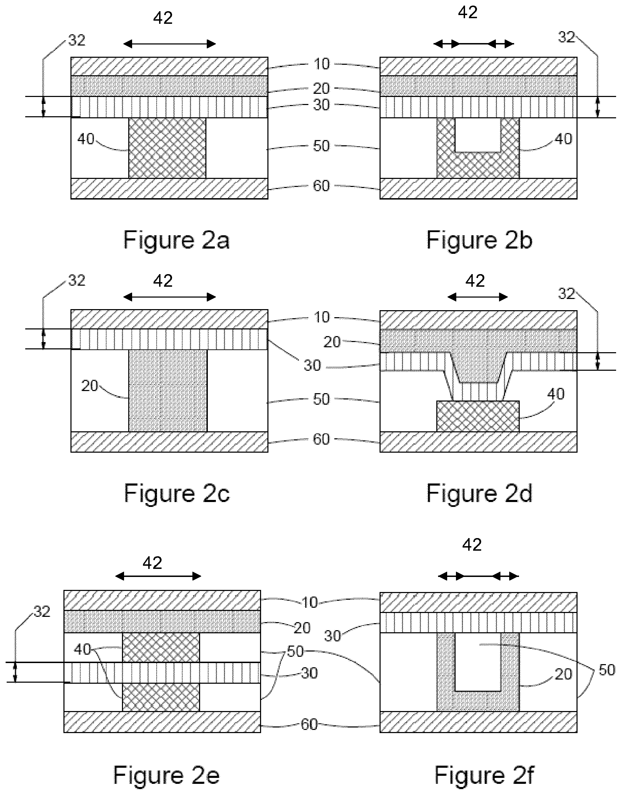

Les **figures 2a à 2f** illustrent des structures de cellule mémoire de type PCM selon l'invention comprenant une fine couche diélectrique 30 additionnelle.

On remarquera que fonctionnellement, quelle que soit la structure, la couche diélectrique 30 est placée pour que dans la cellule mémoire elle se trouve être en série avec les électrodes conductrices 10 et 60, avec la couche de matériau à changement de phase 20 ainsi qu'avec le troisième élément conducteur 40 s'il existe. Les figures 2a à 2f n'illustrent que des exemples particuliers de placement d'une couche diélectrique selon l'invention. On notera notamment, comme représenté dans l'exemple de la figure 2e, que cette couche n'a pas nécessairement à être en contact direct avec le matériau à changement de phase. La seule contrainte est que la couche diélectrique doit être en série avec les électrodes et le matériau à changement de phase et doit empêcher initialement le passage du courant. Ainsi, le courant passant d'une électrode à l'autre doit nécessairement traverser la couche diélectrique 30.

À cette fin, la couche diélectrique 30 est initialement hautement résistive. La résistance électrique initiale d'une cellule mémoire est typiquement supérieure à 10⁷ ohms et de préférence supérieure à 10¹⁰ ohms. Dans la présente demande de brevet, cet état est également qualifié d'état résistif originel ou état « haut ». Il est également désigné par l'acronyme HRS originel (pour état à résistivité élevée originel).

Cet état résistif de la cellule mémoire est obtenu en fin de fabrication de la cellule mémoire et avant toute application d'une tension à la cellule mémoire visant à modifier sa résistance.

Cet état originel ou état « haut » est obtenu après formation de la couche diélectrique et de celles des électrodes. Avantageusement, cet état originel est obtenu à l'issue des phases ultimes du procédé de fabrication qui consistent essentiellement à l'interconnexion des composants élémentaires entre eux, typiquement les cellules mémoire, et vers l'extérieur du dispositif les contenant, à l'aide de plages et de connexions métalliques généralement définies par photolithographie. Ces phases ultimes sont généralement qualifiées de BEOL, acronyme de l'anglais « back-end of line » c'est-à-dire étapes de « fin de ligne » de fabrication. Généralement, au cours de ces étapes de BEOL les cellules mémoires doivent supporter des températures allant jusqu'à 400°C, typiquement, pendant quelques minutes et jusqu'à une dizaine de minutes. De manière avantageuse, l'étape de programmation de la matrice pour amener électriquement un ensemble de cellules sélectionnées depuis l'état hautement résistif originel à l'état moins résistif (LRS) est effectuée après BEOL. De manière également avantageuse, au cours de l'étape d'assemblage, on applique aux cellules mémoire un stress thermique inférieur à celui appliqué lors des étapes de BEOL, typiquement, on applique des températures inférieures à celles appliquées lors des étapes de BEOL.

La couche diélectrique est typiquement constituée d'oxyde d'hafnium (HfO2), d'oxyde de titane (TiO2) ou d'oxyde de zirconium (ZrO2). La couche 30 peut être ajoutée quelle que soit la structure de cellule mémoire considérée. Pour les exemples de structures de l'art antérieur représentées dans les figures 1a à 1d, l'ajout de la couche diélectrique se fait, par exemple, comme représenté respectivement dans les figures 2a à 2d. Comme déjà mentionné ci-dessus la couche diélectrique 30 n'est pas nécessairement en contact avec le matériau à changement de phase 20 et peut par exemple séparer, par exemple en deux, le troisième élément conducteur 40 comme représenté dans la figure 2e.

Plus précisément, sur l'exemple de structure de cellule mémoire illustrée en figure 2a, la couche de matériau diélectrique 30 est disposée entre la couche de matériau à changement de phase 20 et un élément conducteur 40. De préférence, les différents éléments surmontant successivement une électrode 60 sont : un élément conducteur 40, la couche de matériau diélectrique 30, la couche de matériau à changement de phase 20, une autre électrode 10. Selon un mode de réalisation particulier, ces couches sont en contact deux à deux, c'est-à-dire qu'il n'y a pas de couche intermédiaire. Dans cet exemple, l'élément conducteur 40 présente une forme de cylindre plein ou de pilier. De préférence, l'élément conducteur 40 est enrobé d'un matériau diélectrique 50.

Ce mode de réalisation présente pour avantage d'être particulièrement simple à obtenir. Par ailleurs, il permet de réduire la surface de contact entre l'élément conducteur 40 et la couche de matériau diélectrique 30. En effet, cette surface de contact est inférieure à la surface de la face de la couche de matériau diélectrique 30 qui est au contact de l'élément conducteur 40. La zone active, c'est-à-dire la zone qui est soumise à l'application d'un courant et d'une tension est alors restreinte.

L'exemple de structure de cellule mémoire illustrée en figure 2b diffère de celui de la figure 2a en ce que l'élément conducteur 40 présente une forme annulaire ou de tube. Ce mode de réalisation présente pour avantage de réduire encore plus la surface de contact entre l'élément conducteur 40 et la couche de matériau diélectrique 30. Cette surface est un anneau et non pas un disque comme dans la structure de la figure 2a. De préférence, l'élément conducteur 40 en forme de tube est noyé dans une couche de diélectrique 50. Par ailleurs, ce mode de réalisation présente pour avantage de permettre la création d'une aire de contact 42 de taille sub-lithographique. En effet, la taille de l'aire de contact 42 entre l'élément conducteur 40 et la couche de matériau diélectrique 30 dépend directement de l'épaisseur de l'élément conducteur 40. Or celle-ci est contrôlée lors de l'étape de dépôt conforme du matériau conducteur constituant l'élément conducteur 40 et ne requiert donc pas l'utilisation d'étapes de lithographie et de gravure pour contrôler la taille de l'aire de contact 42. Ainsi en s'affranchissant de ces étapes de lithographie et de gravure, il est possible d'obtenir une aire de contact de taille sub-lithographique. Enfin, en s'affranchissant de ces étapes de lithographie et de gravure, ce mode de réalisation présente pour avantage de réduire la complexité du processus de fabrication de la cellule mémoire.

Sur l'exemple de structure de cellule mémoire illustrée en figure 2c, la couche de matériau diélectrique 30 est disposée entre la couche de matériau à changement de phase 20 et une électrode 10. De préférence, les différents éléments surmontant successivement une électrode 60 sont : la couche de matériau à changement de phase 20, la couche de matériau diélectrique 30, une autre électrode 10. Selon un mode de réalisation particulier, ces couches sont en contact deux à deux, c'est-à-dire qu'il n'y a pas de couche intermédiaire. Dans cet exemple, la cellule ne présente pas d'élément conducteur 40 distinct des électrodes 10, 60. Dans cet exemple, la couche de matériau à changement de phase 20 présente une forme de cylindre plein ou de pilier. De préférence, elle est enrobée d'un matériau diélectrique 50. Ce mode de réalisation présente pour avantage d'être particulièrement simple à obtenir. En effet, il ne nécessite pas la fabrication d'un élément conducteur 40 réduisant ainsi la complexité du processus de fabrication de la cellule mémoire. De plus, ce mode de réalisation présente pour avantage de rendre asymétrique la cellule mémoire. En effet, la présence de la couche de matériau diélectrique 30 rend la structure de la cellule mémoire fortement dissymétrique permettant un meilleur contrôle de son fonctionnement ultérieur. Par ailleurs, ce mode de réalisation a pour intérêt de confiner la région dans laquelle le courant passe. Le volume actif du matériau à changement de phase est donc réduit. Cette région active est fonction de la surface de contact entre le matériau à changement de phase 20 et l'électrode. La forme de pilier de la couche de matériau à changement de phase 20 permet ainsi de réduire cette surface de contact, diminuant ainsi le courant nécessaire au fonctionnement de la cellule mémoire.

Cette structure est de préférence obtenue en réalisant une cavité ou un trou traversant dans la couche diélectrique 50 puis en déposant à l'intérieur du trou le matériau à changement de phase 20.

Sur l'exemple de structure de cellule mémoire illustrée en figure 2d, la couche de diélectrique 30 est disposée entre la couche de matériau à changement de phase 20 et un élément conducteur 40 comme sur la figure 2a. En revanche, la couche de matériau à changement de phase 20 épouse le relief du matériau diélectrique 50 enrobant l'élément conducteur 40. La couche de matériau diélectrique 30 épouse également la forme de ce relief. Dans ce mode de réalisation encore, la zone de contact entre l'élément conducteur 40 et la couche de diélectrique 30 est réduite, elle peut par exemple être inférieure à la surface d'un plot formé par l'élément conducteur 40.

Les exemples de structure de cellule mémoire illustrée en figure 2a, 2b, 2c et 2d présentent pour avantage de réduire le courant nécessaire au fonctionnement ultérieur de la cellule mémoire lorsque celle-ci sera écrite en utilisant le mode de fonctionnement conventionnel des mémoires à changement de phase. En effet, lors de l'étape de claquage de la couche de matériau diélectrique 30, un chemin conducteur se créé à travers la couche de matériau diélectrique 30. L'aire de contact entre ce chemin conducteur et la couche de matériau à changement de phase 20 est inférieure ou égale à l'aire de contact entre l'élément conducteur 40 et la couche de matériau diélectrique 30. Or le courant nécessaire au fonctionnement des cellules mémoire à changement de phase est directement lié à l'aire de contact de la plus petite zone conductrice en contact avec la couche de matériau à changement de phase 20. Ainsi en créant un chemin conducteur à travers la couche de matériau diélectrique 30 dont l'aire de contact est inférieure à l'aire de contact de l'élément conducteur 40, le courant nécessaire au fonctionnement ultérieur de la cellule mémoire écrite en utilisant le mode de fonctionnement conventionnel des mémoires à changement de phase est réduit.

La structure de cellule mémoire illustrée en figure 2e, présente deux éléments conducteurs 40, 40 disposés de part et d'autre de la couche de matériau diélectrique 30. De préférence, les différents éléments surmontant successivement une électrode 60 sont : un premier élément conducteur 40, la couche de matériau diélectrique 30, un deuxième élément conducteur 40, la couche de matériau à changement de phase 20, une autre électrode 10. Selon un mode de réalisation particulier, ces couches sont en contact deux à deux, c'est-à-dire qu'il n'y a pas de couche intermédiaire. Dans cet exemple, les éléments conducteurs 40 présentent chacun une forme de cylindre plein ou de tube. De préférence, ils sont noyés dans un matériau diélectrique 50. Ce mode de réalisation présente pour avantage de séparer les couches diélectrique 30 et de matériau à changement de phase 20, ce qui permet l'utilisation de matériaux non compatibles pour ces deux couches.

Sur l'exemple de structure de cellule mémoire illustrée en figure 2f, les différents éléments surmontant successivement une électrode 60 sont : la couche de matériau à changement de phase 20 dont une section est tubulaire, la couche de matériau diélectrique 30, une autre électrode 10. Selon un mode de réalisation particulier, ces couches sont en contact deux à deux, c'est-à-dire qu'il n'y a pas de couche intermédiaire. Dans cet exemple, la cellule ne présente pas d'élément conducteur 40 distinct des électrodes 10, 60. La couche de matériau à changement de phase 20 présente une forme de tube dont une extrémité est close. De préférence, elle est enrobée d'un matériau diélectrique 50.

Ainsi, l'exemple de structure de cellule mémoire illustrée en figure 2f diffère de celui de la figure 2e en ce que le matériau à changement de phase 20 présente une forme annulaire ou de tube. Ce mode de réalisation présente pour avantage de réduire encore plus le volume de la région active du matériau à changement de phase 20. Ce volume est un tube et non pas un cylindre comme dans la structure de la figure 2e. De préférence, le matériau à changement de phase 20 en forme de tube est noyé dans une couche de diélectrique 50. Par ailleurs, ce mode de réalisation présente pour avantage de permettre la création d'une aire de contact 42 de taille sub-lithographique. En effet, la taille de l'aire de contact 42 entre le matériau à changement de phase 20 et la couche de matériau diélectrique 30 dépend directement de l'épaisseur du matériau à changement de phase 20. Or celle-ci est contrôlée lors de l'étape de dépôt conforme du le matériau à changement de phase 20 et ne requiert donc pas l'utilisation d'étapes de lithographie et de gravure pour contrôler la taille de l'aire de contact 42. Ainsi en s'affranchissant de ces étapes de lithographie et de gravure, il est possible d'obtenir une aire de contact de taille sub-lithographique. Enfin, en s'affranchissant de ces étapes de lithographie et de gravure, ce mode de réalisation présente pour avantage de réduire la complexité du processus de fabrication de la cellule mémoire.

Ce dernier comprend avantageusement au moins les étapes suivantes :
- Réalisation d'un trou dans la couche diélectrique 50 ;
- Dépôt conforme d'une couche de matériau à changement de phase 20 sur la couche diélectrique ; Une couche de matériau à changement de phase est ainsi formée et recouvre sur les parois et le fond du trou;
- Remplissage du trou par du matériau diélectrique ; ce remplissage recouvre ainsi le matériau à changement de phase disposé sur les parois du trou et sur le fond du trou ;
- Retrait du matériau à changement de phase situé en dehors de la cavité, de préférence par polissage mécano-chimique (CMP).

Alternativement il est possible de déposer le matériau à changement de phase dans une cavité non traversante de la couche diélectrique puis de rendre accessible le matériau à changement de phase pour sa mise en contact avec l'électrode 60.

De préférence, dans chacun de ces modes de réalisation, l'élément conducteur 40 présente un diamètre externe inférieur à ceux de la couche de matériau à changement de phase 20 et de la couche de diélectrique 30.

Le dépôt de la couche diélectrique 30 se fait typiquement, dans le cas de l'oxyde d'hafnium (HfO2), à une température de 350°C à l'aide d'une méthode dite ALD, acronyme de l'anglais « atomic layer déposition », méthode où l'on expose successivement la surface sur laquelle on pratique le dépôt à différents précurseurs chimiques afin d'obtenir des couches très minces (atomiques). L'opération est répétée autant de fois que nécessaire pour obtenir l'épaisseur 32 souhaitée, entre 2 et 8 nanomètres (nm) dans l'exemple servant à illustrer l'invention. D'autres méthodes de fabrication de la couche diélectrique 30 sont praticables et comprennent possiblement toutes celles couramment mises en oeuvre par l'industrie de la microélectronique pour le dépôt de couches de matériaux divers : pulvérisation, co-pulvérisation, CVD, c'est-à-dire dépôt chimique en phase vapeur et oxydation pour peu qu'elles permettent de conférer à la couche diélectrique 30 les propriétés électriques et physiques adéquates pour l'application considérée.

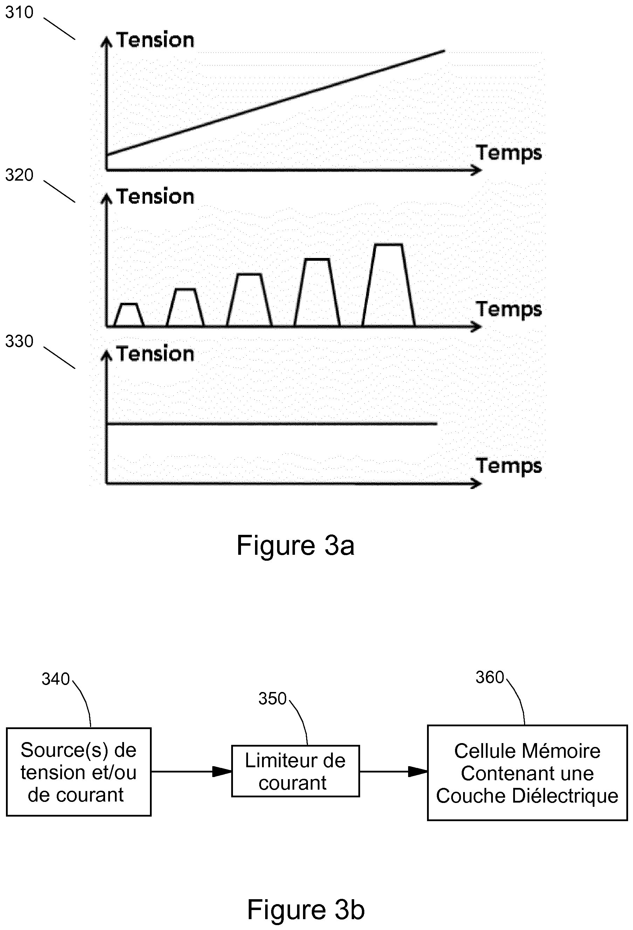

L'invention prévoit qu'au terme d'une procédure électrique décrite dans les figures 3a et 3b, et appliquée à certaines des cellules d'une matrice de cellules mémoire, la couche diélectrique 30 est rendue conductrice dans ces cellules. Cette procédure permet de personnaliser la matrice de cellules mémoire en plaçant certaines d'entre elles dans un quatrième état résistif et en laissant les autres dans l'état hautement résistif c'est à dire l'état HRS originel.

Le quatrième état résistif obtenu en modifiant la couche diélectrique par application d'une tension à la cellule mémoire est qualifié d'état « bas » ou de deuxième état résistif, le premier état résistif étant l'état résistif originel. Il est également désigné par l'acronyme LRS claquage (pour état à résistivité faible obtenu par claquage).

L'information codée en binaire par la cellule dans l'état (LRS claquage) état « bas » sera un « 1 » si l'information codée par la cellule dans état « haut » (HRS originel) est un « 0 ». Inversement, l'information codée en binaire par la cellule dans l'état « bas » claquage sera un « 0 » si l'information codée par la cellule dans l'état « haut » est un « 1 ».

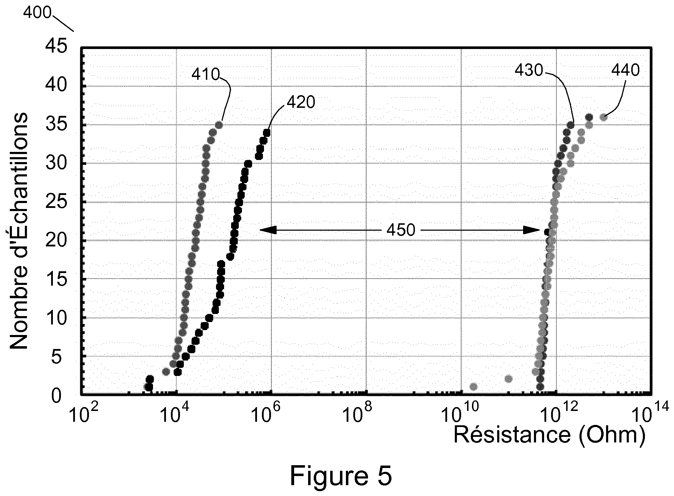

Les états faiblement et hautement résistifs d'une cellule mémoire selon l'invention sont plus particulièrement caractérisés dans la figure 5.

Les **figures 3a et 3b** illustrent des exemples de procédures électriques de mise dans l'état « bas » d'une cellule mémoire.

Une façon de faire 310 consiste à appliquer à la couche diélectrique 30 une différence de potentiel croissante sous la forme d'une rampe de tension depuis une valeur nulle ou minimale jusqu'à une valeur maximale (Vmax) dépendant du matériau diélectrique utilisé, de son épaisseur 32 et de l'aire de l'élément conducteur en contact avec le matériau diélectrique. La tension maximale appliquée à pour but d'obtenir le « claquage », généralement qualifié du terme anglais de « breakdown », de la couche diélectrique.

Alternativement, la procédure électrique de mise dans l'état « bas » d'une cellule consiste à appliquer à la couche diélectrique 30 une différence de potentiel croissante sous la forme d'une succession de pulses de tension 320 depuis une valeur nulle ou minimale jusqu'à une valeur maximale (Vmax) dépendant comme ci-dessus du matériau diélectrique utilisé, de son épaisseur 32 et de l'aire de l'élément conducteur en contact avec le matériau diélectrique.

On peut aussi procéder comme représenté dans le diagramme 330 à l'application directe, pendant un temps déterminé, d'une tension continue suffisante pour assurer le claquage de la couche diélectrique.

Dans tous les cas, comme illustré sur la figure 3b, des circuits internes, ou externes au dispositif, destinés à assurer cette fonction doivent pouvoir délivrer une tension et/ou un courant suffisant à partir d'une source adéquate 340. Par ailleurs, afin de ne pas endommager les cellules mémoire 360 contenant une couche diélectrique qui doit être claquée, les circuits de préprogrammation comprendront avantageusement un circuit limiteur de courant 350.

Une matrice de cellules mémoires selon l'invention peut ainsi être personnalisée avant les étapes de soudure par refusion décrites dans le chapitre sur l'état de la technique sans que leurs états « bas » et « haut » ne soient affectés significativement par le stress thermique de l'assemblage typiquement par brasage ou par soudage par refusion (260°C) comme on le verra dans la figure 5.

Avant l'étape d'assemblage et à l'issue de cette étape, la distribution des résistances des cellules mémoire dans les états « bas » ne chevauche pas la distribution des résistances dans les états « haut ».

Par conséquent, à l'issue des étapes de brasage ou de soudage les données contenues dans une matrice de cellules mémoire personnalisée peuvent ainsi être retrouvées. Avantageusement, ces données sont stockées dans une mémoire temporaire d'un système informatisé contrôlant directement la matrice de cellules mémoires ou le système embarqué la contenant.

La procédure de claquage de la couche diélectrique est alors ensuite appliquée sur tout ou partie des cellules de la matrice.

À l'issue de cette étape, la matrice de cellules mémoire a donc perdu sa personnalisation, tout ou partie des cellules sont dans l'état « bas ». Elles peuvent alors être utilisées comme des cellules mémoires PCM standard puisque la couche diélectrique a été claquée dans toutes les cellules. En particulier, les données spécifiques de personnalisation stockées dans la mémoire temporaire ci-dessus peuvent être réécrites dans les cellules mémoires de la matrice en utilisant le mode d'écriture conventionnel de ces mémoires à changement de phase où l'on fait évoluer électriquement le matériau entre une phase amorphe et au moins une phase cristalline et réciproquement.

Dans les expérimentations qui sont rapportées dans les figures suivantes on a bien constaté que les cellules mémoire à changement de phase n'étaient pas affectées par la présence de la couche diélectrique et retrouvaient leur fonctionnement conventionnel après claquage de cette dernière.

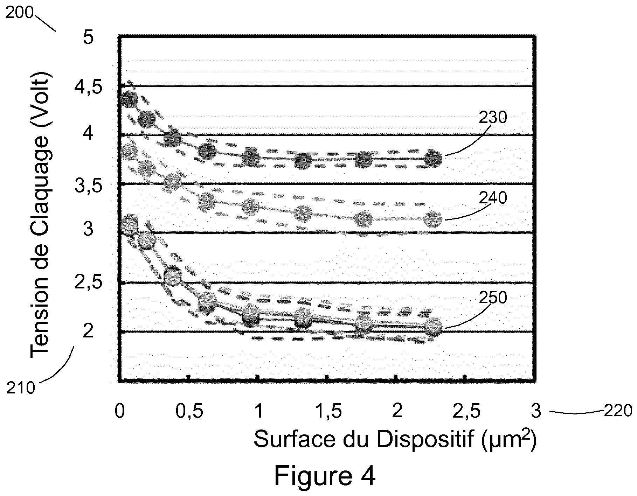

La **figure 4** montre la variation de la tension de claquage pour un dispositif comme représenté sur la figure 2a où la couche diélectrique est faite d'oxyde d'hafnium (HfO2).

Le diagramme 200 montre la dépendance de la tension de claquage 210 par rapport à la surface 220 de l'aire de contact entre la couche de diélectrique 30 et l'élément conducteur 40 pour différentes épaisseurs de HfO2 comprises entre 3 et 8 nm. Les diamètres 42 référencés sur les exemples non limitatifs de structure des figures 2a à 2e indiquent les diamètres des aires de contact entre la couche de diélectrique 30 et l'élément (électrode 10 ou élément conducteur 40) au contact de la couche de diélectrique 30. On constate que lorsque l'aire de contact est faible, et en particulier quand elle est inférieure à 0,5 µm² (µm ou micromètre, soit 10⁻⁶ mètre), la tension de claquage d'une même épaisseur de couche est sensiblement augmentée. Les tensions de claquage les plus élevées 230 sont évidemment obtenues avec l'épaisseur d'oxyde la plus importante c'est-à-dire 8 nm dans cet exemple. Elles diminuent sensiblement quand l'épaisseur diminue à 5 nm 240 et à 3 nm 250. Les courbes en pointillés représentent la dispersion des mesures autour de la moyenne.

On notera ici que pour rester dans une gamme de tensions couramment disponible pour alimenter les dispositifs de type microélectronique, c'est-à-dire 5 volts, il y a lieu de trouver un compromis entre le matériau diélectrique utilisé, son épaisseur et la surface en contact avec l'électrode inférieure. Comme montré dans le diagramme 200, avec le HfO2, on constate que l'épaisseur de la couche diélectrique, pour des surfaces de contact inférieures à 0,5 µm², ne peut donc pas être sensiblement supérieure à 8 nm.

La **figure 5** compare les états faiblement résistifs (états « bas » ou LRS claquage) obtenus après application de la procédure de claquage à ceux hautement résistifs (états « hauts » ou HRS originel) obtenus initialement en fin de cycle de fabrication Le diagramme 400 montre également l'évolution de ces états résistifs après application d'un stress thermique (260°C) comparable à celui subi par les dispositifs programmés lors des étapes de soudure par refusion.

Pour expliquer cela en détail, on peut ainsi qualifier de manière différente l'état d'une cellule avant et après assemblage.

Ainsi, on qualifie de troisième état résistif 440, l'état résistif, après assemblage, d'une cellule mémoire qui était avant assemblage dans l'état résistif originel 430. Cet état est un état fortement résistif. Il est également désigné « HRS assemblage » pour « High Resistive State » après assemblage.

Par ailleurs, on qualifie de quatrième état résistif 420, l'état résistif que présente, après assemblage, une cellule mémoire qui était avant assemblage dans le deuxième état résistif 410 (LRS claquage). Ce quatrième état résistif 420 est un état faiblement résistif. Il est également désigné « LRS assemblage » pour « Low Resistive State » après assemblage.

On remarque que les distributions des états hautement résistifs avant 430 (HRS originel) et après 440 (HRS assemblage) application du stress thermique sont quasiment identiques. Ainsi, les résistances des cellules dans l'état résistif originel (HRS originel) et dans le troisième état résistif (HRS assemblage) sont identiques ou quasiment identiques. Les états faiblement résistifs sont plus sensibles à ce stress. On note un glissement vers des valeurs de résistances plus élevées, après application du stress thermique, de la distribution des états faiblement résistifs 420 par rapport à ce qu'elle était avant 410. Ainsi, les résistances 410 des cellules dans le deuxième état résistif (LRS claquage) sont moins élevées que dans le quatrième état résistif (LRS assemblage) 420. On note toutefois qu'il reste une très grande différence de résistance 450 entre les troisièmes états résistifs (HRS assemblage) et ceux faiblement résistifs (LRS assemblage). Dans cet exemple, cette différence entre les distributions de résistance est d'environ 6 ordres de grandeur (x10⁶). Ceci est largement suffisant pour concevoir un circuit de lecture qui peut discriminer sans ambiguïté les états « bas » des états « hauts » et retrouver le contenu préprogrammé de la matrice de cellules mémoire après les opérations de soudure par refusion. En pratique, un ordre de grandeur (x10) permet d'utiliser un circuit de lecture simple. Un facteur deux entre la résistance maximale de la distribution de l'état LRS et la résistance minimale de la distribution de l'état HRS peut s'avérer être suffisant quoiqu'un facteur 5 ou 10 soit préférable pour permettre l'utilisation d'un circuit de lecture qui reste suffisamment simple et peu coûteux à mettre en oeuvre.

Les résultats ci-dessus ont été établis avec un dispositif correspondant à la structure de la figure 2a ayant une surface de contact circulaire de 300 nm de diamètre et avec une couche diélectrique d'une épaisseur de 3 nm.

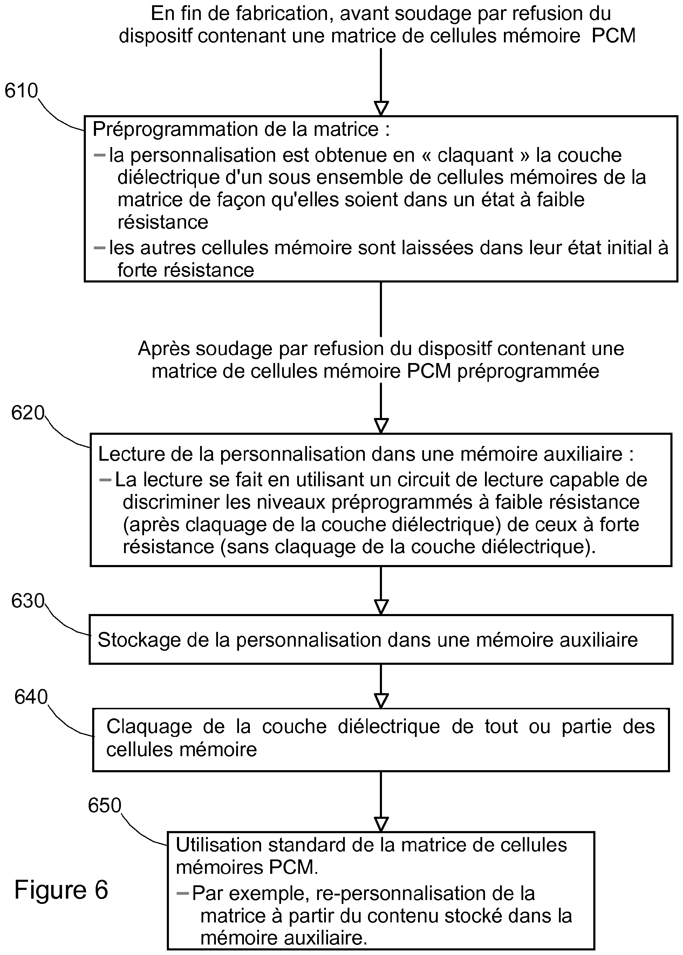

La **figure 6** résume les étapes d'un exemple de procédé de pré-programmation d'une matrice de cellules mémoire de type PCM selon l'invention. Le procédé permet de retrouver, après le stress thermique de l'étape d'assemblage typiquement par brasage ou soudage par refusion, les informations programmées avant cette étape.

L'étape 610 décrit la personnalisation d'une matrice de cellules mémoire PCM selon l'invention, c'est-à-dire de cellules mémoires incluant une couche diélectrique 30 comme illustré en figure 2. La programmation d'une telle matrice consiste à rendre plus faiblement résistant un sous ensemble de cellules de la matrice en provoquant le claquage, dans chacune des cellules du sous ensemble, de la fine couche diélectrique par application d'une procédure électrique dédiée comme décrite précédemment dans les figures 3a et 3b. Chaque cellule est ainsi apte à stocker un bit d'information sous la forme de deux niveaux de résistance électrique : l'un de plus faible résistance (état « bas » ou LRS claquage) obtenu après claquage de la couche diélectrique ; l'autre de plus forte résistance (état « haut » ou HRS originel) correspondant à l'état initial de la cellule en fin de cycle de fabrication. Au cours de l'étape 610 on ne programme donc que les états faiblement résistants.

L'étape suivante 620 est exécutée après que le dispositif contenant la matrice préprogrammée a subi le stress thermique de l'assemblage. Ce stress thermique comprend par exemple une étape au cours de laquelle les cellules mémoire sont soumises à une température d'au moins 240 °C voire d'au moins 260°C pendant plusieurs secondes, et souvent au moins 10 secondes.

Après cette étape consistant généralement à souder ou braser la matrice ou un composant comportant la matrice sur un support tel qu'une carte imprimée, on procède alors à la lecture du contenu de la matrice préprogrammée. Le circuit de lecture utilisé à cette fin est conçu pour différencier les états à faible résistance (LRS assemblage), obtenus après claquage de la couche diélectrique, de ceux à forte résistance (HRS assemblage) correspondant aux cellules mémoires qui ont été laissées dans leur état initial. Le circuit de lecture tient compte des dérives de valeurs de résistance qui peuvent être observées après application du stress thermique. Cette dérive affecte plus particulièrement les états faiblement résistifs comme on l'a vu dans la figure 5. On peut alors identifier les cellules qui avaient initialement être programmées par claquage et celles qui ne l'avaient pas été.

De manière préférée, le procédé comprend des étapes additionnelles et optionnelles. L'étape de lecture 620 du contenu de la matrice préprogrammée s'accompagne d'un stockage 630 des informations lues dans une mémoire auxiliaire. Les informations lues sont typiquement temporairement stockées par le moyen de contrôle du dispositif incluant la matrice mémoire préprogrammée après montage de celui-ci, par exemple, dans un système embarqué.

À l'étape suivante 640, on procède au claquage de tout ou partie des cellules de la matrice préprogrammée de façon à ce que les cellules mémoire puissent alors être utilisées comme des cellules mémoire PCM standard. Cette étape peut optionnellement être exécutée exhaustivement sur l'ensemble des cellules de la matrice ou, disposant à ce stade du contenu de la pré-programmation, n'exécuter cette opération que sur le sous ensemble de cellules qui n'avaient pas déjà été claquées lors de la pré-programmation ou éventuellement sur un sous-ensemble des cellules qui n'avaient pas déjà été claquées lors de la pré-programmation. À l'issue de cette opération, quelle que soit l'option employée, les cellules ayant leur couche diélectrique claquée peuvent être utilisées comme des cellules PCM standard.

On peut donc ensuite 650 utiliser normalement ces cellules de la matrice mémoire PCM et en particulier on peut restaurer les valeurs binaires préprogrammées, depuis la mémoire auxiliaire, en contrôlant cette fois électriquement la phase et donc la résistance de la couche du matériau à changement de phase 20 de la cellule mémoire PCM.

Parmi les avantages qu'apporte l'invention on notera plus particulièrement que l'ajout d'une couche diélectrique peut se pratiquer quels que soient le matériau à changement de phase et la structure de la cellule retenus pour répondre au cahier des charges d'une application particulière d'une matrice de cellules mémoires. On peut toujours ajouter cette couche qui permet aux cellules PCM de retenir les informations préprogrammées en dépit du stress thermique des étapes de soudage par refusion.

La couche supplémentaire s'intègre simplement dans la structure d'une cellule mémoire PCM conventionnelle en procédant à un dépôt du matériau diélectrique, par exemple à un dépôt de type ALD ou en utilisant l'un des procédés standard mis en oeuvre par l'industrie de la microélectronique.

Le procédé de préprogrammation est compatible avec une procédure s'effectuant en fin de ligne de fabrication au niveau tranche, c'est-à-dire avant découpage des puces électroniques dans lesquelles la matrice mémoire est intégrée.

Afin de vérifier qu'une cellule mémoire peut être utilisée dans le cadre de la présente invention, il faut de préférence vérifier les points suivants :
- le diélectrique utilisé (i.e. matériau, épaisseur, aire de contact) doit de préférence pouvoir être rendu conducteur par l'application d'une rampe de tension ou d'une succession de pulses de tension à température ambiante ou encore en appliquant une tension continue suffisante.
- la tension maximum appliquée pendant la rampe de tension ou la succession de pulses de tension ou la valeur de la tension continue doit de préférence être inférieure à la tension maximale que peut délivrer la circuiterie de l'application visée (5V pour les applications mobiles).
- le rapport entre les résistances dans les états « haut » et « bas » doit de préférence être suffisamment important pour être facilement détecté par le système de lecture de l'application visée (typiquement un rapport supérieur à un ordre de grandeur est souhaité).

- après l'étape de soudure, les distributions des résistances des états « haut » et « bas » doivent de préférence ne pas se superposer.
- le matériau diélectrique ne doit pas détériorer le fonctionnement PCRAM ultérieur de la cellule. Par exemple, il ne faut pas qu'il y ait d'interdiffusion entre la couche de diélectrique et le matériau à changement de phase utilisé, par exemple le GST, ce qui pourrait créer un matériau qui n'aurait plus des propriétés de changement de phase ou dont les propriétés seraient dégradées par rapport à celles du matériau à changement de phase initialement retenu notamment en terme de performances telles que la rétention de l'information, les courants de programmation, l'endurance.
- le matériau diélectrique choisit doit de préférence être compatible avec le procédé de fabrication. Par exemple, il ne faut pas que le matériau diélectrique choisit soit incompatible avec les équipements de microélectronique en terme de contamination.

Pour vérifier ces différents points, une approche consiste à tester la viabilité de la solution envisagée:
- en intégrant le matériau diélectrique choisit avec le GST au sein d'une capacité MIM (métal isolant métal) pour tester la possibilité de rendre le matériau diélectrique conducteur ainsi que caractériser la procédure électrique spécifique.
- en intégrant le matériau diélectrique choisit avec le matériau à changement de phase retenu au sein d'une cellule mémoire réelle pour tester le fonctionnement ultérieur de la cellule PCRAM.

La description qui précède décrit plus particulièrement des modes de réalisation dans lesquels l'étape d'assemblage est effectuée par soudage ou par brasage. L'invention s'étend également aux modes de réalisation dans lesquels l'assemblage du composant contenant la matrice de cellules mémoire sur un support est effectué par la méthode dite WLCSP (Wafer Level Chip Scale Packages).

Cette technique d'assemblage a été développée par l'industrie de la microélectronique pour permettre l'assemblage des composants constituant un système embarqué sur un ou plusieurs circuits imprimés. Cette technique repose sur le dépôt, sur le composant à assembler, d'une couche de matériau polymère photo-définissable par exemple un matériau polyimide, c'est-à-dire un matériau polymère contenant un ou plusieurs groupes imide dans sa chaine principale, ou le polybenzobisoxazole également appelé PBO. Ces matériaux étant photo-définissables, la couche ainsi déposée pourra être gravée par exposition à un stimulus lumineux approprié suivi par un développement. Une bille métallique peut alors être déposée dans la cavité tout juste obtenue. Cette bille est responsable des contacts mécanique et électriques entre le composant à assembler et le ou les circuit(s) imprimé(s) correspondant(s).

Dans certains cas, le dépôt de la bille métallique est remplacé par le dépôt d'une couche métallique, par exemple en Cuivre, appelée ReDistribution Layer ou RDL, qui est gravée. Cette couche RDL est alors encapsulée par un matériau polymère photo-définissable qui est à son tour gravé par exposition à un stimulus lumineux approprié et développement. Une bille métallique, responsable des contacts mécanique et électriques entre le composant à assembler et le ou les circuit(s) imprimé(s) correspondant(s), est alors déposée dans la cavité tout juste obtenue.

Dans certains cas, le dépôt de la bille métallique est précédé de l'obtention d'une couche métallique, appelée UBM pour Under Bump metallurgy, en Cuivre ou à base de Nickel (voir Figures ci-dessus).

Bien souvent, la couche ou les couches de matériau polymère doivent être obtenues en suivant un procédé incluant des étapes de recuit à haute température. Nous proposons ci-dessous un exemple des principales étapes nécessaires à l'obtention d'une couche de matériau polymère pouvant être utilisée lors des techniques d'assemblage décrites précédemment :
- Préparation du substrat : T° 80°C-200°C - Durée : 60-240 secondes (s)
- Recuit doux (soft bake) : T° 120°C - Durée : 180 s
- Cure sous Azote (HD8820) :
   ∘ Montée en température : 25°C → 150°C avec une pente de 4°C/min
   ∘ Montée en température: 150°C → 320°C avec une pente de 2,5°C/min
   ∘ Plateau de température: 320°C pendant 1 heure
   ∘ Retour graduel à température ambiante
Les indications ci-dessous concernent un autre exemple de cure sous Azote (HD-4100) :
∘ Montée en température : 25°C → 200°C avec une pente de 10°C/min
∘ Attente à 200°C pendant 30 min
∘ Montée en température : 200°C → 375°C avec une pente de 10°C/min
∘ Plateau de température: 375°C pendant 1 heure
∘ Retour graduel à température ambiante

Ainsi, ces procédés comprennent au moins une étape à une température comprise supérieure à 240°C, souvent supérieure à 300°C et le plus souvent entre 320°C et 375°C pour une durée de plusieurs dizaines de minutes, typiquement 60 minutes.

L'invention permet retrouver après cette étape à très haute température les données sauvegardées avant assemblage.

L'invention n'est pas limitée aux modes de réalisation précédemment décrits mais s'étend à tous les modes de réalisation couverts par la portée des revendications.

## Revendications

1. Procédé de pré-programmation d'une matrice de cellules mémoire résistives non volatiles à changement de phase, comprenant un matériau à changement de phase (20) disposé entre deux électrodes conductrices (10, 60), le matériau à changement de phase (20) étant apte à être modifié électriquement et réversiblement de manière à faire varier la résistance de la cellule mémoire,
chaque cellule mémoire de la matrice comprenant en outre au moins une couche de matériau diélectrique (30) disposée entre les deux électrodes conductrices (10, 60), la cellule mémoire présentant un état résistif originel (HRS originel) (430) en fin de procédé de fabrication de la cellule mémoire,
**caractérisé en ce qu'**on effectue, avant une étape d'assemblage d'un composant contenant ladite matrice avec un support, une étape de pré-programmation de la matrice, l'étape de pré-programmation comprenant :
l'application d'une tension de claquage à un sous ensemble de cellules mémoire de la matrice de manière à, pour chacune des cellules de ce sous ensemble de cellules sélectionnées, faire claquer la couche de matériau diélectrique (30) par un courant traversant le matériau diélectrique pour amener la cellule depuis l'état résistif originel (HRS originel) (430) à un deuxième état résistif (LRS claquage) (410), tel que les cellules se trouvant avant assemblage dans ledit état résistif originel (HRS originel) (430) et dans ledit deuxième état résistif (LRS claquage) (410) se trouvent, après l'étape d'assemblage, respectivement dans un troisième état résistif (HRS assemblage) (440) et dans un quatrième état résistif (LRS assemblage) (420), et que la résistance des cellules se trouvant dans ledit troisième état résistif (HRS assemblage) (440) est au moins deux fois supérieure à la résistance des cellules se trouvant dans ledit quatrième état résistif (LRS assemblage) (420) ;
et **en ce que**, après assemblage, on effectue au moins l'étape suivante: lecture (620) de l'état résistif de toutes les cellules de la matrice de manière à identifier les cellules qui se trouvent après assemblage dans ledit troisième état résistif (HRS assemblage) (440) et celles qui se trouvent dans ledit quatrième état résistif (LRS assemblage) (420).

2. Procédé selon la revendication 1 dans lequel on effectue au moins les étapes suivantes après assemblage d'un composant contenant ladite matrice avec un support:
stockage (630) des états résistifs lus (HRS assemblage, LRS assemblage) dans une mémoire auxiliaire de manière à sauvegarder la pré-programmation de la matrice,
application (640) d'une tension de claquage à une pluralité de cellules mémoire de manière à ce que toutes les couches de matériau diélectrique de toutes les cellules mémoire de la matrice soient claquées,
réécriture (650), dans la matrice, de la pré-programmation sauvegardée dans la mémoire auxiliaire en modifiant le matériau à changement de phase d'une sélection de cellules mémoire.

3. Procédé selon la revendication 2, dans lequel au cours de l'étape d'application d'une tension de claquage à une pluralité de cellules mémoire de manière à ce que toutes les couches de matériau diélectrique de toutes les cellules mémoire de la matrice soient claquées, la tension de claquage est appliquée uniquement aux cellules se trouvant dans ledit troisième état résistif (HRS assemblage) (440) à l'issue de l'étape d'assemblage.

4. Procédé selon l'une quelconque des revendications précédentes dans lequel :
les résistances des cellules mémoire de la matrice dans l'état résistif originel (HRS originel) (430) sont comprises dans une première plage de valeurs, les résistances des cellules mémoire de la matrice dans le deuxième état résistif (LRS claquage) (410) sont comprises dans une deuxième plage de valeurs, dans lequel les première et deuxième plages sont disjointes ;
les résistances des cellules mémoire de la matrice dans ledit troisième état résistif (HRS assemblage) (440) sont comprises dans une première plage de valeurs, les résistances des cellules mémoire de la matrice dans ledit quatrième état résistif (LRS assemblage) (420) sont comprises dans une deuxième plage de valeurs et dans lequel les première et deuxième plages sont disjointes. ;
et dans lequel les première et deuxième plages présentent un écart (450) d'au moins un facteur 10.

5. Procédé selon l'une quelconque des revendications précédentes dans lequel tout le courant passant entre les deux électrodes conductrices (10, 60) traverse le matériau diélectrique (30).

6. Procédé selon l'une quelconque des revendications précédentes dans lequel l'étape d'assemblage comprend une étape d'assemblage par la technique dite de réalisation d'un boitier à la taille d'une puce au niveau du substrat (WLCSP) au cours de laquelle les cellules mémoire sont soumises à une température d'au moins 300 °C pendant au moins 30 minutes.

7. Procédé selon l'une quelconque des revendications précédentes dans lequel la couche diélectrique (30) est au contact d'au moins l'un parmi la couche de matériau à changement de phase (20) et un élément conducteur (40), la surface de contact entre la couche diélectrique (30) et l'au moins un parmi la couche de matériau à changement de phase (20) et un élément conducteur (40) est inférieure à la surface de la face de la couche de diélectrique (30) au regard de l'au moins un parmi la couche de matériau à changement de phase (20) et un élément conducteur (40), .

8. Procédé selon la revendication précédente dans lequel la couche de matériau à changement de phase (20) présente une portion tubulaire et dans laquelle la surface de contact entre la couche de matériau à changement de phase (20) et le matériau diélectrique (30) est un anneau.

9. Procédé selon la revendication 7 dans lequel la couche de matériau à changement de phase (20) est formée d'un cylindre dont la section comprenant son diamètre est inférieure à la surface (42) de la face du matériau diélectrique (30) au contact de ce cylindre.

10. Procédé selon la revendication 7 dans lequel la couche de matériau diélectrique (30) est disposée au contact de la couche de matériau à changement de phase (20) et de l'élément conducteur (40).

11. Procédé selon la revendication précédente dans lequel l'élément conducteur (40) présente une portion tubulaire et dans lequel la surface de contact entre l'élément conducteur (40) et le matériau diélectrique (30) est un anneau.

12. Procédé selon la revendication 7 dans lequel la couche de matériau diélectrique (30) est disposée au contact d'un premier élément conducteur (40) et d'un deuxième élément conducteur (40) et est insérée entre le premier élément conducteur (40) et le deuxième élément conducteur (40).

13. Procédé selon la revendication 7 dans lequel la couche de matériau diélectrique (30) est formée par un matériau pris parmi : l'oxyde d'hafnium (HfO2), l'oxyde de titane (TiO2), l'oxyde de zirconium (ZrO2), l'oxyde de silicium (SiO2).

## Patentansprüche

1. Verfahren zur Vorprogrammierung einer Matrix nicht flüchtiger resistiver Phasenwechsel-Speicherzellen, die ein Phasenwechselmaterial (20) umfassen, das zwischen zwei leitenden Elektroden (10, 60) angeordnet ist, wobei das Phasenwechselmaterial (20) elektrisch und reversibel modifiziert werden kann, um den Widerstand der Speicherzelle zu variieren,
wobei jede Speicherzelle der Matrix weiter mindestens eine Schicht aus dielektrischem Material (30) umfasst, die zwischen den zwei leitenden Elektroden (10, 60) angeordnet ist, wobei die Speicherzelle am Ende des Herstellungsverfahrens der Speicherzelle einen ursprünglichen resistiven Zustand (ursprünglicher HRS) (430) aufweist,
dadurch gegenzeichnet, dass vor einem Schritt des Zusammenbauens einer die Matrix enthaltenden Komponente mit einem Träger ein Schritt des Vorprogrammierens der Matrix durchgeführt wird, wobei der Vorprogrammierschritt umfasst:
das Anlegen einer Durchschlagspannung an einen Teilsatz Speicherzellen der Matrix, um für jede der Zellen dieses Teilsatzes ausgewählter Zellen die dielektrische Materialschicht (30) von einem Strom durchschlagen zu lassen, der das dielektrische Material durchfließt, um die Zelle vom ursprünglichen resistiven Zustand (ursprünglicher HRS) (430) in einen zweiten resistiven Zustand (Durchschlag-LRS) (410) zu überführen, sodass sich die Zellen, die sich vor Zusammenbau im ursprünglichen resistiven Zustand (ursprünglicher HRS) (430) und im zweiten resistiven Zustand (Durchschlag-LRS) (410) befinden, sich nach dem Schritt des Zusammenbauens jeweils in einem dritten resistiven Zustand (Zusammenbau-HRS) (440) und in einem vierten resistiven Zustand (Zusammenbau-LRS) (420) befinden, und dass der Widerstand der Zellen, die sich im dritten resistiven Zustand (Zusammenbau-HRS) (440) befinden, mindestens zweimal höher ist als der Widerstand der Zellen, die sich im vierten resistiven Zustand (Zusammenbau-LRS) (420) befinden;
und dadurch, dass nach dem Zusammenbauen mindestens der folgende Schritt durchgeführt wird: Auslesen (620) des resistiven Zustands aller der Zellen der Matrix, um die Zellen, die sich nach Zusammenbau im dritten resistiven Zustand (Zusammenbau-HRS) (440) befinden, und diejenigen, die sich im vierten resistiven Zustand (Zusammenbau-LRS) (420) befinden, zu identifizieren.

2. Verfahren nach Anspruch 1, wobei nach dem Zusammenbauen einer die Matrix enthaltenden Komponente mit einem Träger mindestens die folgenden Schritte durchgeführt werden:
Speichern (630) der ausgelesenen resistiven Zustände (Zusammenbau-HRS, Zusammenbau-LRS) in einem Hilfsspeicher, um die die Vorprogrammierung der Matrix zu speichern,
Anlegen (640) einer Durchschlagspannung an eine Vielzahl von Speicherzellen, sodass alle die dielektrischen Materialschichten aller der Speicherzellen der Matrix durchgeschlagen werden,
Zurückschreiben (650) der im Hilfsspeicher gespeicherten Vorprogrammierung in die Matrix unter Modifizieren des Phasenwechselmaterials einer Auswahl von Speicherzellen.

3. Verfahren nach Anspruch 2, wobei im Laufe des Schritts des Anlegens einer Durchschlagspannung an eine Vielzahl von Speicherzellen, sodass alle die dielektrischen Materialschichten aller der Speicherzellen der Matrix durchgeschlagen werden, die Durchschlagspannung nur an die Zellen angelegt wird, die sich am Ende des Zusammenbauschritts im dritten resistiven Zustand (Zusammenbau-HRS) (440) befinden.

4. Verfahren nach einem der vorstehenden Ansprüche, wobei:
die Widerstände der Speicherzellen der Matrix im ursprünglichen resistiven Zustand (ursprünglicher HRS) (430) im einem ersten Wertebereich liegen, die Widerstände der Speicherzellen der Matrix im zweiten resistiven Zustand (Durchschlag-LRS) (410) in einem zweiten Wertebereich liegen, wobei der erste und zweite Bereich disjunkt sind;
die Widerstände der Speicherzellen der Matrix im dritten resistiven Zustand (Zusammenbau-HRS) (440) in einem ersten Wertebereich liegen, die Widerstände der Speicherzellen der Matrix im vierten resistiven Zustand (Zusammenbau-LRS) (420) in einem zweiten Wertebereich liegen, und wobei der erste und zweite Bereich disjunkt sind.;
und wobei der erste und zweite Bereich einen Abstand (450) von mindestens einem Faktor 10 aufweisen.

5. Verfahren nach einem der vorstehenden Ansprüche, wobei der ganze Strom, der zwischen den zwei leitenden Elektroden (10, 60) fließt, das dielektrische Material (30) durchfließt.

6. Verfahren nach einem der vorstehenden Ansprüche, wobei der Zusammenbauschritt einen Schritt des Zusammenbauens mit der als Ausführung eines Gehäuses in der Größe eines Chips auf Ebene des Substrats (WLCSP) bezeichneten Technik umfassen, in dessen Verlauf die Speicherzellen während mindestens 30 Minuten einer Temperatur von mindestens 300 °C ausgesetzt werden.

7. Verfahren nach einem der vorstehenden Ansprüche, wobei sich die dielektrische Schicht (30) mit mindestens einem aus der Phasenwechselmaterialschicht (20) und einem leitenden Element (40) in Kontakt befindet, die Kontaktfläche zwischen der dielektrischen Schicht (30) und dem mindestens einem aus der Phasenwechselmaterialschicht (20) und einem leitenden Element (40) kleiner ist als die Fläche der Seite der dielektrischen Schicht (30), die dem mindestens einen aus der Phasenwechselmaterialschicht (20) und einem leitenden Element (40) zugewandt ist,.

8. Verfahren nach dem vorstehenden Anspruch, wobei die Phasenwechselmaterialschicht (20) einen rohrförmigen Abschnitt aufweist, und wobei die Kontaktfläche zwischen der Phasenwechselmaterialschicht (20) und dem dielektrischen Material (30) ein Ring ist.

9. Verfahren nach Anspruch 7, wobei die Phasenwechselmaterialschicht (20) von einem Zylinder gebildet wird, dessen Querschnitt, der seinen Durchmesser umfasst, kleiner ist als die Fläche (42) der Seite des dielektrischen Materials (30), die sich mit diesem Zylinder in Kontakt befindet.

10. Verfahren nach Anspruch 7, wobei die dielektrische Materialschicht (30) mit der Phasenwechselmaterialschicht (20) und dem leitenden Element (40) in Kontakt angeordnet ist.

11. Verfahren nach dem vorstehenden Anspruch, wobei das leitende Element (40) einen rohrförmigen Abschnitt aufweist, und wobei die Kontaktfläche zwischen dem leitenden Element (40) und dem dielektrischen Material (30) ein Ring ist.

12. Verfahren nach Anspruch 7, wobei die dielektrische Materialschicht (30) mit einem ersten leitenden Element (40) und einem zweiten leitenden Element (40) in Kontakt angeordnet ist und zwischen dem ersten leitenden Element (40) und dem zweiten leitenden Element (40) eingefügt ist.

13. Verfahren nach Anspruch 7, wobei die dielektrische Materialschicht (30) von einem Material gebildet wird, ausgewählt aus: Hafniumoxid (HfO2), Titanoxid (TiO2), Zirkoniumoxid (ZrO2), Siliziumoxid (SiO2).

## Claims

1. Method for preprogramming a matrix of phase-changing non-volatile resistive memory cells, comprising a phase-changing material (20) disposed between two conductive electrodes (10, 60), the phase-changing material (20) being able to be modified electrically and reversibly so as to vary the resistance of the memory cell,
each memory cell in the matrix further comprising at least one layer of dielectric material (30) disposed between the two conductive electrodes (10, 60), the memory cell having an original resistive state (original HRS) (430) at the end of the process of manufacturing of the memory cell,
**characterized in that**, before a step of assembling a component containing said matrix with a substrate, a step of preprogramming the matrix is performed, the preprogramming step comprising :
the application of a breakdown voltage to a subset of memory cells in the matrix so as, for each of the cells in this subset of cells selected, to break down the layer of dielectric material (30) with a current passing through the dielectric material in order to bring the cell from the original resistive state (original HRS) (430) to a second resistive state (breakdown LRS) (410), so that the cells that before assembly are in said original resistive state (original HRS) (430) and in said second resistive state (breakdown LRS) (410) are, after the assembly state, respectively in a third resistive state (assembly HRS) (440) and in a fourth resistive state (assembly LRS) (420), and so that the resistance of the cells in said third resistive state (assembly HRS) (440) is at least twice as great as the resistance of the cells in said fourth resistive state (assembly LRS) (420);
and **in that**, after assembly, at least the following step is performed: reading (620) the resistive state of all the cells in the matrix so as to identify the cells that after assembly are in said third resistive state (assembly HRS) (440) and those that are in said fourth resistive state (assembly LRS) (420).

2. Method according to claim 1, wherein at least the following steps are performed after assembly of a component containing said matrix with a substrate:
storing (630) the resistive states read (assembly HRS, assembly LRS) in an auxiliary memory so as to save the preprogramming of the matrix,
applying (640) a breakdown voltage to a plurality of memory cells so that all the layers of dielectric material of all the memory cells in the matrix are broken down,
rewriting (650), in the matrix, the preprogramming saved in the auxiliary memory by modifying the phase-changing material of a selection of memory cells.

3. Method according to claim 2, wherein, during the step of applying a breakdown voltage to a plurality of memory cells so that all the layers of dielectric material of all the memory cells in the matrix are broken down, the breakdown voltage is applied solely to the cells in said third resistive state (assembly HRS) (440) at the end of the assembly step.

4. Method according to any of the preceding claims, wherein:
the resistances of the memory cells in the matrix in the original resistive state (original HRS) (430) lie in a first range of values, the resistances of the memory cells in the matrix in the second resistive state (breakdown LRS) (410) lie in a second range of values, wherein the first and second ranges are separate;
the resistances of the memory cells in the matrix in said third resistive state (assembly HRS) (440) lie in a first range of values, the resistances of the memory cells in the matrix in said fourth resistive state (assembly LRS) (420) lie in a second range of values and wherein the first and second ranges are separate;
and wherein the first and second ranges have a difference (450) of at least a factor of 10.

5. Method according to any of the preceding claims, wherein all the current passing between the two conductive electrodes (10, 60) passes through the dielectric material (30).

6. Method according to any of the preceding claims, wherein the assembly step comprises a step of assembling by the technique known as producing a wafer-level chip-scale package (WLCSP) in the course of which the memory cells are subjected to a temperature of at least 300°C for at least 30 minutes.

7. Method according to any of the preceding claims, wherein the dielectric layer (30) is in contact with at least one from the layer of phase changing material (20) and a conductive element (40), the surface of contact between the dielectric layer (30) and the at least one from the layer of phase changing material (20) and a conductive element (40) is smaller than the surface of the face of the dielectric layer (30) facing the at least one from the layer of phase changing material (20) and a conductive element (40).

8. Method according to the preceding claim, wherein the layer of phase changing material (20) has a tubular portion and wherein the surface of contact between the layer of phase changing material (20) and the dielectric material (30) is an annulus.

9. Method according to claim 7, wherein the layer of phase changing material (20) is formed by a cylinder, the cross-section of which comprising its diameter is smaller than the surface (42) of the phase of the dielectric material (30) in contact with the cylinder.

10. Method according to claim 7, wherein the layer of dielectric material (30) is disposed in contact with the layer of phase changing material (20) and the conductive element (40).

11. Method according to the preceding claim, wherein the conductive element (40) has a tubular portion and wherein the contact surface between the conductive element (40) and the dielectric material (30) is an annulus.

12. Method according to claim 7, wherein the layer of dielectric material (30) is disposed in contact with a first conductive element (40) and a second conductive element (40) and is inserted between the first conductive element (40) and the second conductive element (40).

13. Method according to claim 7, wherein the layer of dielectric material (30) is formed by a material taken from: hafnium oxide (HfO2), titanium oxide (TiO2), zirconium oxide (ZrO₂) and silicon oxide (SiO2).
